Europäisches Patentamt

European Patent Office

Office européen des brevets

(19)

(11) **EP 1 447 842 A1**

(12) **EUROPEAN PATENT APPLICATION**
published in accordance with Art. 158(3) EPC

(43) Date of publication:
18.08.2004 Bulletin 2004/34

(21) Application number: 02802024.6

(22) Date of filing: 17.10.2002

(51) Int Cl.7: **H01L 21/60**

(86) International application number:
**PCT/JP2002/010784**

(87) International publication number:
**WO 2003/036710 (01.05.2003 Gazette 2003/18)**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: 23.10.2001  JP 2001324376
05.06.2002  JP 2002164920
20.08.2002  JP 2002239967

(71) Applicant: **Sunitomo Electric Wintec, Incorporated**
**Kouka-gun, Shiga 529-1811 (JP)**

(72) Inventors:
• **KAIMORI, S. SUMITOMO ELECTRIC IND. LTD.**
**Osaka-shi, Osaka 554-0024 (JP)**

• **NONAKA, T. Sumitomo Electric Wintec, Inc.**
**Kouka-gun, Shiga 529-1811 (JP)**
• **FUKAGAYA, M. Sumitomo Electric Wintec, Inc.**
**Kouka-gun, Shiga 529-1811 (JP)**
• **IOKA, M. Sumitomo Electric Wintec, Inc.**
**Kouka-gun, Shiga 529-1811 (JP)**

(74) Representative:
**Cross, Rupert Edward Blount et al**
**BOULT WADE TENNANT,**
**Verulam Gardens**
**70 Gray's Inn Road**
**London WC1X 8BT (GB)**

(54) **BONDING WIRE**

(57)     A bonding wire having a core mainly consisting of copper and a coating layer formed on the core, wherein the coating layer is made of an oxidation-resistant metal having a melting point higher than that of copper, and the elongation of this bonding wire per unit sectional area is 0.021%/$\mu m^2$ or more; and a bonding wire having a core mainly consisting of copper and a coating layer formed on the core, wherein the coating layer is made of a metal having oxidation resistance higher than that of copper, and the relationship of $0.007 \leqq X \leqq 0.05$ is satisfied wherein an area ratio X is (the area of the coating layer/the area of the core at the section of wire being cut vertically) are provided. The bonding wires thus provided are inexpensive and excellent in ball formation characteristic and bonding characteristic. Further, a ball bonding method characterized in using the above bonding wire is also provided.

EP 1 447 842 A1

**Description**

**TECHNICAL FIELD**

The present invention relates to a bonding wire suitable for connecting electrodes on integrated circuit chips (ICs, LSIs, transistors and the like) to conductive wires on circuit wiring substrates (lead frames, ceramic substrates, printed circuit boards and the like), and also relates to a ball bonding method using the bonding wire.

**BACKGROUND ART**

As the methods of connecting integrated circuit chips to circuit wiring substrates, the ball bonding method, wedge bonding method, solder bonding method, resistance welding method and the like are used. Among these, the ball bonding method using thin gold wires is generally used.

Usually, the ball bonding method is carried out according to the following process. The tip of a wire guided by a movable capillary (hereafter referred to as a "bonding tool") is melted by electric discharge between the wire and an electrode torch, thereby forming a ball. While ultrasound is applied, the ball is pressed against an electrode on an integrated circuit chip serving as a first bonding point, thereby carrying out bonding (first bonding). Thereafter, while the wire is being fed, the bonding tool is moved to an electrode on a circuit wiring substrate serving as a second bonding point, and bonding is carried out, too (second bonding). In the second bonding, no ball is formed. After the bonding, the bonding tool is raised, and a clamp pulls the wire to cut it.

Gold is generally used as the material for this kind of bonding wire. However, since gold is expensive, a bonding wire made of a metal other than gold, that is, an inexpensive metal, is desired to be developed. To meet this need, a bonding wire made of copper obtainable at low cost has been developed. However, the copper bonding wire has the problems that:

since the surface of the copper bonding wire is liable to be oxidized, it is difficult to store the wire for a long period; oxidation advances owing to heat conduction from the substrate during bonding, resulting in defective bonding; and the like.

Accordingly, in order to prevent the surface of the copper bonding wire from oxidation, bonding wires coated with noble metals such as gold or corrosion-resistant metals have been proposed (Japanese Laid-open Patent Application No. 62-97360). These wires are far less expensive than the gold bonding wire and it is believed that they can attain an excellent bonding characteristic without causing surface oxidation.

However, as semiconductor devices are made more integrated and more compact, that is, as the distance between adjacent wires is narrowed, the gold-plated copper bonding wire causes a new problem as follows. Forming small-diameter balls is indispensable to narrow the distance between adjacent wires. However, if an attempt is made to form small-diameter balls by using the gold-plated copper bonding wire, the balls do not have the shape of a true sphere, but have the shape of a spear, and the reproducibility of the shape is unstable, thereby causing a problem of lower bonding reliability.

In addition, in order to narrow the distance between adjacent wires, it is necessary to carry out bonding by using a bonding tool having a small bottom area. In this case, in particular, the bonding area at the second bonding point wherein the wire is not melted becomes smaller, thereby causing a problem of lower bonding strength.

Furthermore, when balls are formed from the copper bonding wire, a mixture gas of nitrogen and hydrogen is used as a shield gas. However, hydrogen may cause the danger of explosion. To prevent the explosion, a hydrogen leakage detector or the like is required, resulting in higher cost.

A main object of the present invention is to provide an inexpensive bonding wire excellent in ball formation characteristic and bonding characteristic.

Another object of the present invention is to provide a ball bonding method capable of forming small-diameter balls.

**DISCLOSURE OF INVENTION**

The present invention attains the above-mentioned objects by limiting the material and the rupture elongation (hereafter simply referred to as an "elongation" unless otherwise specified) of a bonding wire.

The bonding wire of the present invention is a bonding wire having a core mainly consisting of copper and a coating layer formed on the core, wherein the coating layer is made of an oxidation-resistant metal having a melting point higher than that of copper, and the elongation of this bonding wire per unit sectional area is 0.021%/$\mu m^2$ or more.

The bonding wire of the present invention is also a bonding wire having a core mainly consisting of copper and a coating layer formed on the core, wherein the coating layer is made of a metal having oxidation resistance higher than that of copper, and the relationship of $0.007 \leqq X \leqq 0.05$ is satisfied wherein an area ratio X is (the area of the coating layer/the area of the core at the section of wire being cut vertically).

**BRIEF DESCRIPTION OF DRAWINGS**

FIG. 1 (A) is an explanatory view showing the cut end portion of a wire being bent at the tip;
FIG. 1 (B) is an explanatory view showing the cut end portion of a wire resulting in the shape of a straight line;
FIG. 2 is an explanatory view showing a looping characteristic evaluation standard; and
FIG. 3 is an explanatory view of an angle θ.

**Description of reference codes**

1. Wire
2. Torch

**BEST MODE FOR CARRYING OUT THE INVENTION**

By limiting the materials of the core and the coating layer as described above, and by specifying the elongation per unit sectional area, a ball having the shape of a nearly true sphere and having the center not deviated from the center of the wire, in particular such a ball having a small diameter, can be formed stably during melting, whereby highly reliable bonding can be attained. Herein, the ball having a small diameter refers to a ball having a diameter less than three times the diameter of the wire.

In addition, since the wire has a high elongation, the wire is hard to rupture, and a high bonding strength can be obtained even at the second bonding point wherein the wire is not melted. Furthermore, when the bonding tool moves from the first bonding point to the second bonding point, the wire can smoothly follow the movement.

As a result of an extensive study regarding the influence of the materials of the core and the coating layer of the bonding wire on the ball shape stability during the ball formation, we have found that, if the melting point of the coating layer material is higher than that of the core material, the copper wire, the defect of forming balls having the shape of a spear during the formation of small-diameter balls, which occurs in the case of the gold-plated copper wire, does not occur, whereby balls having a proper shape are apt to be obtained. If the melting point of the coating layer material is higher than that of copper, the coating layer material is prevented from diffusing and melting into the copper wire, whereby it is speculated that the balls can hold the shape of a true sphere. Therefore, the present invention is characterized in that a metal having a melting point higher than that of copper and oxidation resistance higher than that of copper is used for the coating layer. The melting point is preferably 200 °C, more preferably 300 °C, higher than that of copper. Particularly, at least one kind of metals selected from palladium, platinum and nickel is preferable. An alloy containing two or more kinds of metals selected from palladium, platinum and nickel may also be used as the coating layer material, as a matter of course. The melting point of copper is 1084°C, the melting point of palladium is 1554°C, the melting point of platinum is 1772°C, and the melting point of nickel is 1455°C. Although the material of the coating layer mainly consists of the above-mentioned elements, an alloy containing other element(s) can be used as the material, if the melting point of the alloy is higher than that of copper. In particular, palladium is preferable, since it is superior to nickel in oxidation resistance and also superior to platinum in processability (wiredrawing can be done easily). The thickness of the coating layer is preferably about 0.1 to 0.0001 times the diameter of the core wire, although the preferred thickness differs depending on the wire diameter.

On the other hand, in the wires coated with these metals, the center of the ball is apt to deviate from the axis of the wire during ball formation, thereby being apt to cause a problem of forming a ball having the so-called shape of golf-club. This problem becomes conspicuous when balls having large diameters are formed. Even when balls having small diameters are formed, the defect of the shape of golf-club occurs in a certain proportion if the number of samples is very large. However, the proportion of this defect tends to increase when balls having large diameters are formed. As a result of an examination on the correlation between the various physical properties of wires and the ball formation characteristic of the wires, we have found that there is a correlation between the elongation per unit sectional area of the wire and the defect in the ball shape.

Generally, in the case of a gold bonding wire, a wire having an elongation per unit sectional area of about 0.005 to 0.015%/$\mu m^2$ is used. In the case of a copper wire, just as in the case of the gold wire, the elongation is set at a similar value; or by reflecting the fact that a copper wire is liable to be elongated by processing in comparison with a gold wire, a copper wire having a somewhat higher elongation of up to $0.020\%/\mu m^2$ is used frequently. However, as a result of an examination, we have found that a wire has excellent ball formation characteristic if its elongation per unit sectional area is $0.021\%/\mu m^2$ or more. The elongation per unit sectional area is preferably $0.024\%/\mu m^2$ or more and more preferably $0.030\%/\mu m^2$ or more.

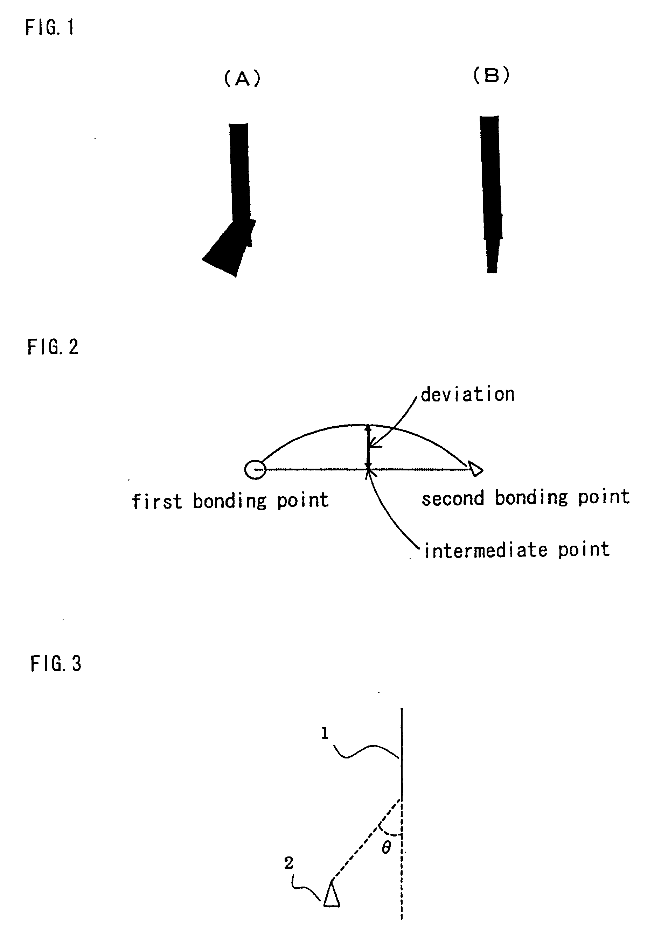

It is speculated that the favorable ball formation characteristic is due to the fact that, as shown in FIG. 1, in the case of a wire having high elongation, the cut end portion is apt to become a shape of a straight line (FIG. 1 (B)) when the wire is held with a clamp and pulled to cut it after the second bonding, while, in the case of a wire having low elongation, the cut end portion is apt to be bent at the tip, whereby leading to a shape of golf-club in the next ball formation(FIG. 1 (A)).

A coated copper wire is not liable to elongate owing to the coating.

The elongation per unit sectional area in accordance with the present invention is a value obtained by dividing the wire elongation rate (%) at the time when a wire of 10 cm long is pulled at a pulling speed of 20 mm/min and ruptured by the sectional area of the wire (the total area ($\mu m^2$) of the core and the coating layer) before the pulling.

The electroplating method is particularly suitable as the method of forming the coating layer. The method of obtaining a target wire diameter and a target plating thickness by drawing a thickly-plated thick copper wire several times is economical and preferable. Particularly, a wire obtained by the combination of electroplating and wire drawing is excellent in the uniformity of the thickness and the smoothness of the surface, and the friction between the wire and the inner face of the wire through hole in the bonding tool is small, whereby the wire feeding characteristic is excellent. Furthermore, since the contact force between the core and the coating layer is high, the problem of clogging the through hole of the bonding tool with chips coming off from the coating layer can be solved.

Usually, the bonding wire is drawn to obtain a final wire diameter and then subjected to annealing (final annealing) to adjust the elongation.

The elongation becomes saturated at a final annealing temperature of about 440°C, although it differs depending on the wire diameter. Even if the annealing temperature is raised further, the improvement of the elongation cannot be expected so much. Conversely, if the annealing temperature is too high, the elongation tends to lower. When the final annealing temperature is optimized, the maximum elongations of about 9%, 13% and 16% can be obtained for wires having diameters of 20 $\mu m$, 25 $\mu m$ and 28 $\mu m$, respectively, as shown in the examples described later.

As a result of an extensive examination, we have found that, by carrying out annealing in the middle of the wiredrawing step after coating layer formation (referred to as intermediate annealing) in addition to the final annealing, a bonding wire having a high elongation, that is difficult to be obtained only by the final annealing, can be obtained. By adopting this intermediate annealing, a bonding wire having a high elongation of $0.030\%/\mu m^2$ or more can be obtained.

Furthermore, we have also found that the wire having a high elongation has some advantages other than the characteristic of forming balls having the shape of a true sphere. One advantage is an improvement in the controllability of the shape of a wire loop. Since the metals such as palladium, platinum and nickel are hard, the bendability of a copper wire coated with such a metal lowers. As a result, when the bonding tool is moved from the first bonding point to the second bonding point, the wire cannot smoothly follow the movement, thereby causing a problem of difficult loop shape control. If the loop shape is distorted or has variations, defective contacts between adjacent wires increase, and, in a terrible case, an unusual tensile stress is applied to the first bonding point during looping, resulting in disconnection at the bonding portion. By using a wire having a high elongation of $0.021\%/\mu m^2$ or more per unit sectional area, high bendability of the wire can be attained and the controllability of the loop shape of the wire can be improved.

Another advantage is the fact that the bonding strength for the second bonding increases. The bonding strength mentioned herein is a pull bonding strength correlating to the rupture strength of the wire at the time when the wire is pulled and flown by a stream of melted resin in a downstream step wherein a bonded chip is subjected to resin encapsulating. This bonding strength is evaluated by raising the bonded wire with a hook and by measuring the rupture load of the wire. The wire is usually ruptured at the boundary between the circular sectional portion and the flat portion crushed by the bonding tool.

During the second bonding, a wire liable to elongate has a larger bonding width when crushed by the bonding tool. Hence, the force exerted from the wire during the measurement of the bonding strength is dispersed at this bonding portion, and stress concentration is hard to occur, whereby it is speculated that high bonding strength is obtained. Furthermore, when the wire is pulled and ruptured, if the wire itself is liable to elongate, stress concentration is hard to occur, whereby the wire is hard to crack. Even if the wire cracks, rupture owing to stress concentration is hard to occur, whereby it is also speculated that high bonding strength is obtained.

As mentioned above, the bonding wire of the present invention includes a bonding wire having a core mainly consisting of copper and a coating layer formed on the core, wherein the coating layer is made of a metal having oxidation resistance higher than that of copper, and the relationship of $0.007 \leqq X \leqq 0.05$ is satisfied wherein a area ratio X is (the area of the coating layer/the area of the core) at the section of wire being cut vertically.

As a result of an examination, we have found that by limiting the area ratio of the core and the coating layer as described above, balls of a true sphere can be formed, and that the fraction defective resulting in having the shape of a golf club can be reduced. The area ratio X in the range of $0.01 \leqq X \leqq 0.04$ is particularly preferable.

The area ratio X can be adjusted easily by changing the thickness of the coating layer. Regarding the relationship between the thickness of the coating layer and the elongation, the elongation of a wire with a coating layer is smaller than that of a wire without coating layer, and the elongation is apt to become smaller as the coating layer is thicker.

In addition, the coating layer is preferably made of a material having heat of fusion different from that of the core by 25 cal/g or less. By using the coating layer made of a material having heat of fusion different from that of the core by 25 cal/g or less, balls having the shape of a nearly true sphere and having a diameter less than three times the wire diameter can be formed easily during bonding.

As a result of an extensive study on the reasons for the problems that the balls have the shape of a spear and the reproducibility of the ball size becomes unstable, when small-diameter balls are formed by using a gold-plated copper bonding wire, we have reached a conclusion that, when the tip of the wire is melted by electrical discharge to form a ball, the gold having heat of fusion lower than that of the copper has higher priority in melting (copper: 49 cal/g, gold: 16 cal/g), whereby the copper having higher heat of fusion remains as the core. In the case when balls to be formed are small, heat energy supplied by electrical discharge is small, and the influence of the difference in heat of fusion between the copper and the gold becomes more conspicuous, whereby it is speculated that balls having the shape of a true sphere are hard to be formed.

As the materials having heat of fusion different from that of the core by 25 cal/g or less, palladium, platinum and nickel described above are exemplified. The heat of fusion of palladium is 36 cal/g, the heat of fusion of platinum is 27 cal/g, and the heat of fusion of nickel is 70 cal/g. Difference of 20 cal/g or less in heat of fusion is more preferable, since the ball shape to be formed has smaller variations.

The total amount of elements other than copper, contained in the core, is preferably 0.001 % by weight or more and 1 % by weight or less. As a result of repeated examinations for attaining the "high elongation" characteristic, we have found that the characteristic is significantly influenced by impurities. Conventionally, a gold wire having a total amount of impurities of 0.001 % by weight or less has been used. A copper wire having similar purity is frequently used. However, in the coated wire of the present invention, it is desirable that the core intentionally contains more than 0.001 % by weight of elements other than copper in order to obtain the "high elongation" characteristic. An amount of impurities of 0.01 % by weight or more is more preferable.

As the impurities to be contained in the core, beryllium, tin, zinc, zirconium, silver, chromium, iron, oxygen, sulfur and hydrogen are exemplified. By setting the contained amount of impurities at a specific value or more as described above, it is possible to obtain a high elongation characteristic that is hard to be attained when the amount of impurities is small. Furthermore, even in the case when the high elongation characteristic is not specifically aimed, wire breakage during processing and the like can be reduced significantly in comparison with the case when the amount of impurities is small. However, if the amount of elements other than copper is excessive, electrical characteristics become inferior, for example, electrical resistance increases, and the balls have a crater-like surface when balls are formed. From this point of view, the total amount of elements other than copper is preferably 1 % by weight or less.

Furthermore, by containing 10 to 1000 ppm by weight of at least one kind of elements selected from antimony, phosphorus, lithium, tin, lead, cadmium and bismuth in the core, the difference in heat of fusion between the core and the coating layer can be made smaller. The heat of fusion of each metal is as follows: antimony : 39 cal/g, tin : 14 cal/g, lead : 5.5 cal/g, cadmium : 14 cal/g and bismuth : 13 cal/g.

The diameter of the wire of the present invention is not specifically limited. In the case when small-diameter balls are aimed, the wire diameter is preferably 15 to 40 μm.

The ball bonding method of the present invention is characterized in that the above-mentioned bonding wire of the present invention is used. According to the ball bonding method of the present invention, small-diameter balls having a diameter less than three times the diameter of the wire are formed during ball bonding.

By using the above-mentioned bonding wire of the present invention, bonding can be carried out while small-diameter balls having the shape of a nearly true sphere are formed. Hence, bonding can be carried out at higher bonding strength at a smaller bonding area, and the distance between adjacent wires can be reduced, whereby high-density integrated circuits can be formed. In order to satisfy the need for increasing the density of semiconductor devices in recent years, the ball diameter is frequently required to be 60 μm or less.

In the ball bonding method of the present invention characterized in using the above-mentioned bonding wire of the present invention, the shield gas which may be used during ball formation is not specifically limited and, for example, a nitrogen gas not containing hydrogen as well as a mixture gas of nitrogen and hydrogen may be used. When a nitrogen gas not containing hydrogen is used, that having a nitrogen purity of 99.9% or more is preferable.

Since the above-mentioned bonding wire of the present invention is coated on the surface with an oxidation-resistant metal, such as a noble metal, defects owing to oxidation are hard to occur in comparison with the copper bonding wire. Hence, a favorable ball state can be obtained even when low-purity nitrogen gas is used. In other words, if the purity of nitrogen is 99.9% or more, favorable balls being excellent in true sphere formation characteristic and having no craters on the surface can be obtained. Although nitrogen gas having higher purity is desirable, nitrogen gas guaranteed to have a purity of 99.9995% or more is expensive and thus undesirable in view of cost.

As methods of supplying an inert gas, such as nitrogen gas, during ball formation, various methods are devised. For example, a method of spraying the gas to the tip of the wire from one or more gas pipes, and a method of enclosing the periphery of the tip of the wire with walls and supplying the inert gas inside the walls to store the gas therein can be mentioned. In the case of the simplest supplying method wherein the inert gas is sprayed to the tip of the wire from one gas pipe, the value obtained by dividing the gas flow rate by the open area of the gas pipe is preferably 0.01 to 2.5 litters/min · mm$^2$. If the value is less than 0.01 litters/min · mm$^2$, it is difficult to attain a sufficient gas shield characteristic. On the other hand, if the value is more than 2.5 litters/min · mm$^2$, the cooling capability by the gas spraying is excessive, thereby causing defects that small balls are hard to be formed and, further, the balls are deformed, for example.

In the ball bonding methods of the present invention characterized in using the above-mentioned bonding wire of the present invention, it is preferable that the angle θ between the straight line connecting from the tip of the wire to the discharge point of the torch and the extension line of the wire satisfies $0 < \theta \leqq 45$ degrees.

As a result of an examination on the correlations between the ball formation factors (methods and conditions) and the fraction defective thereof, we have found that there are correlations between some factors and the fraction defective. One of them is the angle between the straight line connecting from the tip of the wire to the discharge point of the torch and the extension line of the wire during ball formation. This angle 0 is preferably $0 < \theta \leqq 45$ degrees. The angle is more preferably 20 degrees or less, since the probability of occurrence of a favorable ball shape increases.

A movable torch and a fixed torch are generally known as discharge electrodes for the ball bonding methods. The movable torch is moved to the position directly below the tip of the wire only during ball formation by electrical discharge. After ball formation, the torch is moved away from the position directly below the tip of the wire. However, the movable torch may cause defects of taking time for ball formation, since the torch requires movement time, of liable to cause failures owing to its complicated structure, whereby ball formation becomes unstable, and the like. On the other hand, in the case of the fixed torch, the torch is fixed at a position slightly away from the position directly below the tip of the bonding wire to prevent the capillary from colliding with the torch when the capillary lowers to the bonding point after ball formation. In the present invention, when using the fixed torch and limiting the angle θ as above, ball formation can be done in a short time, and favorable balls having the shape of a true sphere can be formed.

Embodiments of the present invention will be described below.

Prototype example 1

<Production of wire>

Various coating layers were formed by electrical plating on copper bonding wires having a diameter of 200 μm, one layer on each wire, and then the wires were drawn to obtain a desired diameter. As the final step, the wires were passed through a furnace of 50 cm long at a wire speed of 30 m/min, whereby the wires were subjected to annealing for adjusting elongation. The temperatures of the furnace are shown in Tables 1 and 2. Each wire of 10 cm long is pulled at a pulling speed of 20 mm/min until the wire ruptures, and its elongation is evaluated by: 100 × (the distance between marks after rupture - the distance between marks before pulling)/the distance between marks before pulling. The elongation per unit sectional area is a value obtained by dividing the elongation obtained by the above equation by the sectional area (the total area "μm$^2$" of the core and the coating layer) of the wire before pulling.

<Examination on ball formation characteristic>

By using a bonder (Model FB137 produced by KAIJO Corporation), 100 balls having a desired diameter were formed, and the fraction defective of the shape at that time was examined. Balls having the shape of a true sphere were judged to be "proper". In the case of a Pd-plated wire and a Ni-plated wire, balls having the shape of a golf club (the center of the ball is deviated from the extension line of the wire) were judged to be "improper". In the case of an Au-plated wire, balls having the shape of a spear were judged to be "improper". As ball formation conditions, the distance between the tip of the wire and the spark rod (torch) was set at 400μm, and nitrogen having a purity of 99.999% was sprayed to the tip of the wire at a flow rate of 1 litter/min to reduce the concentration of the oxygen around the tip. The balls were formed in these conditions.

For evaluating ball formation characteristic, wires having a diameter of 20 μm were used to form balls having a diameter of 60 μm, wires having a diameter of 25 μm were used to form balls having a diameter of 70 μm and wires having a diameter of 28 μm were used to form balls having a diameter of 80 μm, and when the fraction defective of wire is 9/100 or less, the wire was judged to be "proper".

<Examination on bonding strength>

At a substrate temperature of 200°C, by using a bonding tool having a bottom face diameter of 130 μm, first bonding was carried out to the aluminum pad on an IC electrode and second bonding was carried out to a lead frame (Ag-plated) to connect the first bonding point and the second bonding point with a wire at a distance of 3 mm and to form a loop. The shape of the loop is "NORMAL," and the height of the loop is "300 μm." The bonding strengths of the second bonding were measured for 40 loops of each wire, and the average bonding strength was calculated. For measuring bonding strength, the wire was hooked near the second bonding point and pulled at 0.5 mm/sec, and the strength (g) at the time of rupture was measured. The strength (g) was used as the bonding strength.

<Examination on looping characteristic>

At a substrate temperature of 200°C, by using a bonding tool having a bottom face diameter of 130 μm, the aluminum pad on an IC electrode and a lead frame (Ag-plated) were connected with a wire at a distance between the first bonding point and the second bonding point of 2 mm. The shape of the loop is "HIGH," and the height of the loop is "200 μm." As shown in FIG. 2, when the loop was viewed from above, the deviation (distance) from the intermediate point of the line connecting between the first bonding point and the second bonding point to the loop was measured. This deviation was used as a guide for evaluating the stability of the loop shape. The average value for 30 loops was adopted as the evaluation value. Examples 1 to 3 and 15, and comparative examples 1 to 3

By using a copper bonding wire containing impurities other than copper in the total amount of 0.05 % by weight, a wire having a diameter* of 20 μm and a Pd-plating thickness of 0.1 μm was produced. By changing the processing conditions and the annealing conditions during the production, wires having elongations shown in Tables 1 and 2 were produced. In Example 15, intermediate annealing was carried out. By using these wires, the ball formation characteristic and bonding strength were evaluated for balls having a diameter of 60 μm. The results of the evaluation are shown in Tables 3 and 4.

(*: outer diameter of wire having a core and a coating layer.)

Examples 4 to 6 and 16, and comparative examples 4 to 6

By using a copper bonding wire containing impurities other than copper in the total amount of 0.05 % by weight, a wire having a diameter of 25 μm and a Pd-plating thickness of 0.1 μm was produced. By changing the processing conditions and the annealing conditions during the production, wires having elongations shown in Tables 1 and 2 were produced. In Example 16, intermediate annealing was carried out. By using these wires, the ball formation characteristic and bonding strength were evaluated for balls having a diameter of 70 μm. Further, the looping characteristic was also evaluated. The results of the evaluation are shown in Tables 3 and 4.

Examples 7 to 8, and comparative examples 7 to 9

By using a copper bonding wire containing impurities other than copper in the total amount of 0.005 % by weight, a wire having a diameter of 25 μm and a Pd-plating thickness of 0.1 μm was produced. By changing the processing conditions and the annealing conditions during the production, wires having elongations shown in Tables 1 and 2 were produced. By using these wires, the ball formation characteristic and bonding strength were evaluated for balls having a diameter of 70 μm. The results of the evaluation are shown in Tables 3 and 4.

Comparative examples 10 to 11

By using a copper bonding wire containing impurities other than copper in the total amount of 0.0005 % by weight, a wire having a diameter of 25 μm and a Pd-plating thickness of 0.1 μm was produced. By changing the processing conditions and the annealing conditions during the production, wires having elongations shown in Table 2 were produced. By using these wires, the ball formation characteristic and bonding strength were evaluated for balls having a diameter of 70 μm. The results of the evaluation are shown in Table 4.

In wires having elongations higher than those of comparative examples 10 and 11, problems of wire breakage and the like were caused during the wiredrawing step. Hence, it was difficult to produce stable long-wound products.

Examples 9 to 11 and 17, and comparative examples 12 to 14

By using a copper bonding wire containing impurities other than copper in the total amount of 0.05 % by weight, a wire having a diameter of 28 µm and a Pd-plating thickness of 0.1 µm was produced. By changing the processing conditions and the annealing conditions during the production, wires having elongations shown in Tables 1 and 2 were produced. By using these wires, the ball formation characteristic and bonding strength were evaluated for balls having a diameter of 80 µm. In Example 17, intermediate annealing was carried out. The results of the evaluation are shown in Tables 3 and 4.

Comparative examples 15 to 16

By using a copper bonding wire containing impurities other than copper in the total amount of 0.05 % by weight, a wire having a diameter of 25 µm and a Au-plating thickness of 0.1 µm was produced. By changing the processing conditions and the annealing conditions during the production, wires having elongations shown in Table 2 were produced. By using these wires, the ball formation characteristic and bonding strength were evaluated for balls having a diameter of 70 µm. The results of the evaluation are shown in Table 4.

Examples 12 to 14, and comparative examples 17 to 19

By using a copper bonding wire containing impurities other than copper in the total amount of 0.05 % by weight, a wire having a diameter of 25 µm and a Ni-plating thickness of 0.1 µm was produced. By changing the processing conditions and the annealing conditions during the production, wires having elongations shown in Tables 1 and 2 were produced. By using these wires, the ball formation characteristic and bonding strength were evaluated for balls having a diameter of 70 µm. The results of the evaluation are shown in Tables 3 and 4.

Table 1

| Sample | Diameter of Wire ($\mu$m) | Core | | Coating layer | | Annealing temperature (℃) | | Elongation per unit sectional area ($\%/\mu m^2$) | Elongation (%) |
|---|---|---|---|---|---|---|---|---|---|
| | | Material | Concentration of impurities (% by weight) | Thickness ($\mu$m) | Material | Intermediate | Final | | |
| Example 1 | 20 | Cu | 0.05 | 0.1 | Pd | - | 340 | 0.022 | 6.9 |
| Example 2 | 20 | Cu | 0.05 | 0.1 | Pd | - | 345 | 0.024 | 7.5 |
| Example 3 | 20 | Cu | 0.05 | 0.1 | Pd | - | 400 | 0.026 | 8.2 |
| Example 4 | 25 | Cu | 0.05 | 0.1 | Pd | - | 370 | 0.022 | 11 |
| Example 5 | 25 | Cu | 0.05 | 0.1 | Pd | - | 425 | 0.024 | 12 |
| Example 6 | 25 | Cu | 0.05 | 0.1 | Pd | - | 450 | 0.026 | 13 |
| Example 7 | 25 | Cu | 0.005 | 0.1 | Pd | - | 390 | 0.022 | 11 |
| Example 8 | 25 | Cu | 0.005 | 0.1 | Pd | - | 445 | 0.024 | 12 |
| Example 9 | 28 | Cu | 0.05 | 0.1 | Pd | - | 370 | 0.022 | 14 |
| Example 10 | 28 | Cu | 0.05 | 0.1 | Pd | - | 390 | 0.024 | 15 |
| Example 11 | 28 | Cu | 0.05 | 0.1 | Pd | - | 410 | 0.026 | 16 |
| Example 12 | 25 | Cu | 0.05 | 0.1 | Ni | - | 370 | 0.022 | 11 |
| Example 13 | 25 | Cu | 0.05 | 0.1 | Ni | - | 425 | 0.024 | 12 |
| Example 14 | 25 | Cu | 0.05 | 0.1 | Ni | - | 450 | 0.026 | 13 |
| Example 15 | 20 | Cu | 0.05 | 0.1 | Pd | 440 | 440 | 0.038 | 11.9 |
| Example 16 | 25 | Cu | 0.05 | 0.1 | Pd | 450 | 450 | 0.034 | 17 |
| Example 17 | 28 | Cu | 0.05 | 0.1 | Pd | 450 | 450 | 0.034 | 21 |

EP 1 447 842 A1

Table 2

| Sample (No.of Comparative example) | Diameter of Wire (μm) | Core Material | Core Concentration of impurities (% by weight) | Coating layer Thickness (μm) | Coating layer Material | Final Annealing temperature (°C) | Elongation per unit sectional area (%/μm²) | Elongation (%) |
|---|---|---|---|---|---|---|---|---|
| 1 | 20 | Cu | 0.05 | 0.1 | Pd | 310 | 0.012 | 3.8 |
| 2 | 20 | Cu | 0.05 | 0.1 | Pd | 315 | 0.016 | 5.0 |
| 3 | 20 | Cu | 0.05 | 0.1 | Pd | 330 | 0.020 | 6.3 |
| 4 | 25 | Cu | 0.05 | 0.1 | Pd | 330 | 0.012 | 6 |
| 5 | 25 | Cu | 0.05 | 0.1 | Pd | 340 | 0.016 | 8 |
| 6 | 25 | Cu | 0.05 | 0.1 | Pd | 355 | 0.020 | 10 |
| 7 | 25 | Cu | 0.005 | 0.1 | Pd | 335 | 0.012 | 6 |
| 8 | 25 | Cu | 0.005 | 0.1 | Pd | 345 | 0.016 | 8 |
| 9 | 25 | Cu | 0.005 | 0.1 | Pd | 355 | 0.020 | 10 |
| 10 | 25 | Cu | 0.0005 | 0.1 | Pd | 350 | 0.012 | 6 |
| 11 | 25 | Cu | 0.0005 | 0.1 | Pd | 400 | 0.016 | 8 |
| 12 | 28 | Cu | 0.05 | 0.1 | Pd | 320 | 0.012 | 7 |
| 13 | 28 | Cu | 0.05 | 0.1 | Pd | 340 | 0.016 | 10 |
| 14 | 28 | Cu | 0.05 | 0.1 | Pd | 355 | 0.020 | 12 |
| 15 | 25 | Cu | 0.05 | 0.1 | Au | 340 | 0.016 | 8 |
| 16 | 25 | Cu | 0.05 | 0.1 | Au | 370 | 0.022 | 11 |
| 17 | 25 | Cu | 0.05 | 0.1 | Ni | 330 | 0.012 | 6 |
| 18 | 25 | Cu | 0.05 | 0.1 | Ni | 340 | 0.016 | 8 |
| 19 | 25 | Cu | 0.05 | 0.1 | Ni | 355 | 0.020 | 10 |

Table 3

| Sample | Fraction defective of ball formation characteristic | Bonding strength (g) | Deviation of loop | |
|---|---|---|---|---|
| | | | Average (µm) | Ratio of deviation of 50 µm or more |
| Example 1 | 9/100 | 4.3 | | |
| Example 2 | 7/100 | 4.6 | | |
| Example 3 | 5/100 | 4.5 | | |
| Example 4 | 8/100 | 8.5 | 44 | 13/30 |
| Example 5 | 4/100 | 8.3 | 41 | 9/30 |
| Example 6 | 1/100 | 8.7 | 42 | 10/30 |
| Example 7 | 6/100 | 8.0 | | |
| Example 8 | 5/100 | 8.1 | | |
| Example 9 | 7/100 | 10.3 | | |
| Example 10 | 6/100 | 10.6 | | |
| Example 11 | 2/100 | 10.6 | | |
| Example 12 | 4/100 | | | |
| Example 13 | 2/100 | | | |
| Example 14 | 0/100 | | | |
| Example 15, | 0/100 | | | |
| Example 16 | 0/100 | | | |
| Example 17 | 0/100 | | | |

Table 4

| Sample (No.of Comparative example) | Fraction defective of ball formation characteristic | Bonding strength (g) | Deviation of loop | |
|---|---|---|---|---|
| | | | Average (µm) | Ratio of deviation of 50 µm or more |
| 1 | 23/100 | 3.6 | | |
| 2 | 18/100 | 3.7 | | |
| 3 | 12/100 | 4.1 | | |
| 4 | 19/100 | 7.0 | 67 | 22/30 |
| 5 | 16/100 | 7.4 | 73 | 25/30 |
| 6 | 13/100 | 7.7 | 53 | 19/30 |
| 7 | 17/100 | 7.2 | | |
| 8 | 16/100 | 7.2 | | |
| 9 | 10/100 | 7.4 | | |
| 10 | 20/100 | 6.8 | | |
| 11 | 15/100 | 7.2 | | |
| 12 | 16/100 | 8.8 | | |

Table 4   (continued)

| Sample (No.of Comparative example) | Fraction defective of ball formation characteristic | Bonding strength (g) | Deviation of loop | |
|---|---|---|---|---|
| | | | Average (µm) | Ratio of deviation of 50 µm or more |
| 13 | 13/100 | 9.1 | | |
| 14 | 10/100 | 10.1 | | |
| 15 | 60/100* | | | |
| 16 | 63/100* | | | |
| 17 | 14/100 | | | |
| 18 | 11/100 | | | |
| 19 | 6/100 | 4.0 | | |

* spear shape

As apparent from the comparison between the above-mentioned examples and comparative examples, it is found that the examples are superior in all of the ball formation characteristic, bonding strength and looping characteristic. In particular, Examples 15 to 17 having been subjected to intermediate annealing can attain a high elongation per unit sectional area of 0.030%/µm$^2$ or more, and the fraction defectives of the ball formation characteristic in these examples are zero.

Prototype example 2

A copper bonding wire having a purity of 99.995% and a diameter of 200 µm was subjected to electrical plating so that the wire was coated with a coating layer of palladium, gold or nickel having a thickness of 0.81 µm. This wire was drawn to produce a palladium-, gold- or nickel-plated copper bonding wire having a diameter of 25 µm and a plating layer thickness of 0.1 µm.
By using a bonder (Model FB137 produced by KAIJO Corporation), balls having various diameters were formed from these bonding wires, and the number of defective balls and their main improper shapes were examined. The results are shown in Table 5.
The diameters of the balls were determined by the diameters of the true spheres that were formed in the same conditions. Ball formation was carried out in the conditions wherein the distance between the tip of the wire and the spark rod was set at 400 µm, and nitrogen having a purity of 99.999% was sprayed to the tip of the wire at a flow rate of 1 litter/min to reduce concentration of the oxygen around the tip.
In the case of the gold-plated copper bonding wire, spear-shaped defects occurred frequently when the ball diameter was smaller than three times the wire diameter. On the other hand, in the case of the palladium- or nickel-plated copper bonding wire, balls having the shape of a true sphere were formed stably even when the ball diameter was smaller than three times the wire diameter, and proper bonding was attained even in the case of high-density wiring.

Table 5

| Ball diameter (µm) | Metal for coating layer | | |
|---|---|---|---|
| | Palladium | Gold | Nickel |
| 40 | 0 | 49 (spear shape) | 0 |
| 50 | 0 | 48 (spear shape) | 0 |
| 60 | 0 | 45 (spear shape) | 0 |
| 70 | 5 (golf-club shape) | 30 (spear shape) | 3 (golf-club shape) |
| 80 | 15 (golf-club shape) | 0 | 10 (golf-club shape) |
| Each number in the table designates the number of defects in 50 pieces. | | | |

Prototype example 3

A copper bonding wire containing impurities other than copper in the total amount of 0.05 % by weight and having a diameter of 200 μm was subjected to electrical plating so that the wire was coated with a palladium layer having a desired thickness. This wire was drawn and then subjected to final annealing (450°C) to produce bonding wires shown in Tables 6-8.

By using a bonder (Model FB137 produced by KAIJO Corporation), 100 balls having a diameter of 70 μm were formed from these bonding wires, while nitrogen having a purity of 99.999% was sprayed from one side at a flow rate of 0.5 litters/min/mm$^2$ (the value obtained by dividing the flow rate of the gas by the open area of the gas pipe), and the probability of ball deformation to the shape of golf-club was examined. Wires having a fraction defective of 9/100 or less were judged to be "proper", and wires having a fraction defective of 10/100 or more were judged to be "improper".

The area ratio X was obtained by the following equation:

$$X = \text{(the area of plating layer/the area of core)} =$$

$$(a^2 - (a - b)^2)/(a - b)^2$$

wherein a is the radius of the plated wire, and b is the plating layer thickness.

The results of the examination are shown in Tables 6 to 8. As apparent from these tables, it is found that the fraction defective resulting in having the shape of golf-club is low when the area ratio X is in the range of $0.007 \leqq X \leqq 0.05$.

Table 6

|  | Comparative example | Example | | | Comparative example | |
|---|---|---|---|---|---|---|
|  | 21 | 21 | 22 | 23 | 22 | 23 |
| Wire diameter(μm) | 20 | ← | ← | ← | ← | ← |
| Plating layer thickness (μm) | 0.01 | 0.05 | 0.1 | 0.2 | 0.3 | 0.5 |
| Area ratio X | 0.002 | 0.010 | 0.020 | 0.041 | 0.063 | 0.108 |
| Golf-club shape | 10/100 | 4/100 | 5/100 | 8/100 | 11/100 | 27/100 |

Table 7

|  | Comparative example | Example | | | | Comparative example |
|---|---|---|---|---|---|---|
|  | 24 | 24 | 25 | 26 | 27 | 25 |
| Wire diameter (μm) | 25 | ← | ← | ← | ← | ← |
| Plating layer thickness (μm) | 0.01 | 0.05 | 0.1 | 0.2 | 0.3 | 0.5 |
| Area ratio X | 0.002 | 0.008 | 0.016 | 0.033 | 0.050 | 0.085 |
| Golf-club shape | 11/100 | 7/100 | 1/100 | 2/100 | 9/100 | 25/100 |

Table 8

|  | Comparative example | Example | | | | Comparative example |
|---|---|---|---|---|---|---|
|  | 26 | 28 | 29 | 30 | 31 | 27 |
| Wire diameter(μm) | 28 | ← | ← | ← | ← | ← |
| Plating layer thickness (μm) | 0.01 | 0.05 | 0.1 | 0.2 | 0.3 | 0.5 |
| Area ratio X | 0.001 | 0.007 | 0.014 | 0.029 | 0.044 | 0.075 |

Table 8   (continued)

|  | Comparative example | Example | | | | Comparative example |
|---|---|---|---|---|---|---|
|  | 26 | 28 | 29 | 30 | 31 | 27 |
| Golf-club shape | 13/100 | 8/100 | 2/100 | 2/100 | 7/100 | 21/100 |

Prototype example 4

A copper bonding wire having a purity of 99.95% and a diameter of 200 μm was subjected to electrical plating so that the wire was coated with a coating layer of palladium having a thickness of 0.81 μm. This wire was drawn and subjected to final annealing (425°C). As a result, palladium-plated copper bonding wires having a diameter of 25 μm, a plating layer thickness of 0.1 μm and an elongation per unit sectional area of 0.024%/μm$^2$ were produced.

By using a bonder (Model FB137 produced by KAIJO Corporation), 100 balls having a diameter of 70 μm were formed from these bonding wires, while nitrogen was sprayed from one side at a flow rate of 0.5 litters/min/mm$^2$ (the value obtained by dividing the flow rate of the gas by the open area of the gas pipe), and the correlation between the purity of nitrogen and the presence or absence of craters on the surface was examined. Craters on the surface were checked by a scanning electron microscope (SEM). The results are shown in Table 9. As apparent from this table, it is found that favorable balls without craters on the surface can be formed when the purity of nitrogen gas is 99.9% or more.

Table 9

|  | Example | | Comparative example | |
|---|---|---|---|---|
|  | 41 | 42 | 41 | 42 |
| Plating material | Pd | ← | ← | Not plated |
| Purity of nitrogen gas (%) | 99.99 | 99.9 | 99 | 99.9 |
| Craters on surface | Not found | Not found | Found | Found |

Prototype example 5

A copper bonding wire having a purity of 99.95% and a diameter of 200 μm was subjected to electrical plating so that the wire was coated with a coating layer of palladium having a thickness of 0.81 μm. This wire was drawn and then subjected to final annealing (425°C) to produce a palladium-plated copper bonding wire having a core diameter of 25 μm, a plating layer thickness of 0.1 μm and an elongation per unit sectional area of 0.024%/μm$^2$.

By using a prototype bonder capable of changing the positions of the tip of the wire and the discharge point (the distance between the tip of the wire and the discharge point being set constant), 50 balls having a diameter of 60 μm were formed from this wire at each of various values of angle θ, and the probability of ball deformation to the shape of golf-club was examined. As shown in FIG. 3, a wire 1 is disposed vertically with its tip directed downward, and the angle θ is designated by the angle formed between the straight line connecting from the tip of the wire to the discharge point of a torch 2 and the extension line of the wire. Ball formation was carried out while nitrogen having a purity of 99.999% was sprayed from one side at a flow rate of 0.5 litters/min/mm$^2$ (the value obtained by dividing the flow rate of the gas by the open area of the gas pipe). The ball formation wherein the probability of ball deformation to the shape of golf-club was 14/50 or less and applicability to a fixed torch was attained was judged to be "proper". The results are shown in Table 10. As shown in Table 10, it is found that the probability of ball deformation to the shape of golf-club can be reduced when the angle θ is about 45 degrees or less.

Table 10

|  | Example | | | | Comparative example | | | |
|---|---|---|---|---|---|---|---|---|
|  | 51 | 52 | 53 | 54 | 51 | 52 | 53 | 54 |
| Angle θ (degrees) | 10 | 20 | 30 | 40 | 0 | 50 | 60 | 90 |
| Golf-club shape | 0/50 | 1/50 | 5/50 | 13/50 | 0/50 | 23/50 | 31/50 | 50/50 |
| Applicability to fixed torch | Applicable | ← | ← | ← | Not applicable | Applicable | ← | ← |

**INDUSTRIAL APPLICABILITY**

As described above, forming a coating layer made of an oxidation-resistant metal having a melting point higher than that of copper on the core mainly consisting of copper and by setting the elongation of the wire per unit sectional area at 0.021%/$\mu$m$^2$ or more, the bonding wire of the present invention can attain an excellent true sphere formation characteristic, bonding characteristic and looping characteristic. When X = (the area of coating layer/the area of core) is in the range of $0.007 \leqq X \leqq 0.05$, balls being excellent in the true sphere formation characteristic can be formed similarly.

Moreover, small-diameter balls can be formed stably according to the ball bonding method of the present invention. As the result, bonding can be carried out in a smaller bonding area, and bonding for high-density wiring is made possible by narrowing the distance between adjacent wires, whereby high-density integrated circuits can be formed.

**Claims**

1. A bonding wire having a core mainly consisting of copper and a coating layer formed on the core, wherein the coating layer is made of an oxidation-resistant metal having a melting point higher than that of copper, and the elongation of this bonding wire per unit sectional area is 0.021%/$\mu$m$^2$ or more.

2. The bonding wire according to Claim 1, wherein a metal having a melting point 200 °C higher than that of copper is used for the coating layer.

3. A bonding wire having a core mainly consisting of copper and a coating layer formed on the core, wherein the coating layer is made of a metal having oxidation resistance higher than that of copper, and the relationship of $0.007 \leqq X \leqq 0.05$ is satisfied wherein an area ratio X is (the area of the coating layer/the area of the core at the section of wire being cut vertically).

4. The bonding wire according to Claim 3, wherein X is in the range of $0.01 \leqq X \leqq 0.04$.

5. The bonding wire according to any one of Claims 1-4, wherein at least one kind of metals selected from palladium, platinum and nickel is used for the coating layer.

6. The bonding wire according to any one of Claims 1-5, wherein the total amount of elements other than copper contained in the core is 0.001 % by weight or more and 1 % by weight or less.

7. The bonding wire according to any one of Claims 1-6, wherein the coating layer is made of a material having heat of fusion different from heat of fusion of the core by 25 cal/g or less.

8. The bonding wire according to any one of Claims 1-7, wherein the core contains at least one kind of elements selected from antimony, phosphorus, lithium, tin, lead, cadmium and bismuth in an amount from 10 to 1000 ppm by weight.

9. The bonding wire according to any one of Claims 1-8, wherein the coating layer is formed by the electroplating method.

10. A ball bonding method **characterized in that** the bonding wire according to any one of Claims 1-9 is used.

11. The ball bonding method according to Claim 10, wherein small-diameter balls having a diameter less than three times the diameter of the wire are formed during ball bonding.

12. A ball bonding method according to Claim 10 or 11, wherein nitrogen gas having a nitrogen purity of 99.9% or more is used as a shield gas during ball formation.

13. A ball bonding method according to any one of Claims 10 to 12, wherein the angle $\theta$ between the straight line connecting from the tip of the wire to the discharge point of the torch and the extension line of the wire satisfies $0 < \theta \leqq 45$ degrees.

FIG. 1

(A)                    (B)

FIG. 2

deviation

first bonding point          second bonding point

intermediate point

FIG. 3

1

2

θ

**EP 1 447 842 A1**

<table>
<tr><td colspan="2" style="text-align:center"><b>INTERNATIONAL SEARCH REPORT</b></td><td>International application No.<br><br>PCT/JP02/10784</td></tr>
</table>

| A. CLASSIFICATION OF SUBJECT MATTER |
|---|
| Int.Cl$^7$ H01L21/60 |
| |
| According to International Patent Classification (IPC) or to both national classification and IPC |

| B. FIELDS SEARCHED |
|---|
| Minimum documentation searched (classification system followed by classification symbols) |
| Int.Cl$^7$ H01L21/60 |
| |
| Documentation searched other than minimum documentation to the extent that such documents are included in the fields searched |
| Jitsuyo Shinan Koho      1922-1996   Toroku Jitsuyo Shinan Koho   1994-2003<br>Kokai Jitsuyo Shinan Koho  1971-2003   Jitsuyo Shinan Toroku Koho   1996-2003 |
| Electronic data base consulted during the international search (name of data base and, where practicable, search terms used) |
| |

| C. | DOCUMENTS CONSIDERED TO BE RELEVANT | |
|---|---|---|
| Category* | Citation of document, with indication, where appropriate, of the relevant passages | Relevant to claim No. |
| X<br>Y<br>A | JP 62-97360 A (Mitsubishi Metal Corp.),<br>06 May, 1987 (06.05.87),<br>Page 2, upper right column, line 1 to lower left<br>column, line 15; table 1<br>(Family: none) | 3-6,9,10<br>7,11-13<br>1,2,8 |
| Y<br>A | JP 10-98061 A (Kobe Steel, Ltd.),<br>14 April, 1998 (14.04.98),<br>Par. Nos. [0008], [0014], [0015]<br>(Family: none) | 7,12<br>3-6,8-10 |
| A | JP 63-64211 A (The Furukawa Electric Co., Ltd.),<br>22 March, 1988 (22.03.88),<br>Page 2, lower left column, line 12 to lower right<br>column, line 8; page 3, upper right column, line<br>13 to lower left column, line 8<br>(Family: none) | 1 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 20 January, 2003 (20.01.03) | 04 February, 2003 (04.02.03) |
| Name and mailing address of the ISA/<br>   Japanese Patent Office | Authorized officer |
| Facsimile No. | Telephone No. |

Form PCT/ISA/210 (second sheet) (July 1998)

**INTERNATIONAL SEARCH REPORT**

| International application No. |
| --- |
| PCT/JP02/10784 |

| C (Continuation). | DOCUMENTS CONSIDERED TO BE RELEVANT | |
| --- | --- | --- |

| Category* | Citation of document, with indication, where appropriate, of the relevant passages | Relevant to claim No. |
| --- | --- | --- |
| A | JP 63-79926 A (Fujikura Densen Kabushiki Kaisha), 09 April, 1988 (09.04.88), Claims (Family: none) | 8 |
| A | JP 63-79927 A (Fujikura Densen Kabushiki Kaisha), 09 April, 1988 (09.04.88), Claims (Family: none) | 8 |
| Y | US 6041995 A (Kabushiki Kaisha Shinkawa), 28 March, 2000 (28.03.00), Column 3, lines 21 to 28; Fig. 2 & JP 10-256296 A | 11 |
| Y | JP 1-256134 A (Hitachi, Ltd.), 12 October, 1989 (12.10.89), Page 4, lower right column, line 17 to page 5, upper left column, line 3 (Family: none) | 12 |
| Y | US 4705204 A (Mitsubishi Denki Kabushiki Kaisha), 10 November, 1987 (10.11.87), Column 5, lines 13 to 15 & JP 61-208230 A | 12 |
| Y | JP 5-243315 A (Kinsei Electron Kabushiki Kaisha), 21 September, 1993 (21.09.93), Column 2, lines 14 to 22 & KR 9408316 B | 13 |

Form PCT/ISA/210 (continuation of second sheet) (July 1998)